# EUROPEAN PATENT APPLICATION

(11) **EP 4 471 431 A1**
(43) Date of publication of application: **04.12.2024**
(21) Application number: 24174601.5
(22) Date of filing: 07.05.2024
(51) Int. Cl.: G01P 15/097, G01P 15/09, G01P 15/08, B81B 7/00, B81C 1/00

(54) **VIBRATING BEAM ACCELEROMETER**

(30) Priority: 01.06.2023 US 202363505540 P; 08.09.2023 US 202318463545
(71) Applicant: Honeywell International Inc., Charlotte, NC 28202 (US)
(72) Inventor: MILNE, James Christopher, Charlotte, 28202 (US); DWYER, Paul W., Charlotte, 28202 (US); BECKA, Stephen F., Charlotte, 28202 (US)
(74) Representative: Haseltine Lake Kempner LLP

(57) **Abstract**

An example proof mass assembly includes a proof mass, a proof mass support, and a flexure connecting the proof mass to the proof mass support. The proof mass is configured to rotate relative to the proof mass support via the flexure. The proof mass assembly includes a resonator beam connected to a first major surface of the proof mass and a first major surface of the proof mass support. The resonator beam includes a first electrode disposed on a surface of the resonator beam and a second electrode disposed on the surface of the resonator beam that is configured to have an opposite charge than that of the first electrode. The resonator beam comprises a gap between the first electrode and the second electrode on the surface of the resonator beam that is less than or equal to 250 micrometers.

## Description

This application claims the benefit of U.S. Provisional Application No. 63/505,540 filed June 1, 2023, the entire contents of which is incorporated herein by reference.

### TECHNICAL FIELD

The present disclosure relates to vibrating beam accelerometers, also referred to as resonating beam accelerometers.

### BACKGROUND

Accelerometers function by detecting the displacement of a proof mass under inertial forces. One technique of detecting the force and acceleration is to measure the displacement of the mass relative to a frame. Another technique is to measure the force induced in resonators as they counteract inertial forces of the proof mass. The acceleration may, for example, be determined by measuring the change in the frequencies of the resonators due to the change in load generated by the Newtonian force of a proof mass experiencing acceleration.

### SUMMARY

The disclosure describes laser etched vibrating beam accelerometers (VBAs) and techniques for making laser etched VBAs. For example, a VBA described herein may be comprised of a proof mass assembly and one or more resonators, which may be double ended tuning fork (DETF) type resonators comprising resonator beams. Electrodes may be fabricated onto the resonator beams and selective laser etching may be used to form the electrodes. For example, the electrodes may be formed by coating or depositing electrically conductive material onto a surface of a resonator beam, and selective laser etching may be used to form or shape the electrodes, e.g., via removing a portion of resonator beam material on which the electrically conductive material is deposited or by shaping or forming the resonator beam material to control which portions of the surface of the resonator beam are coated with the electrically conductive material. Control of the formation and/or shape of the electrodes fabricated onto the resonator beams may improve the accuracy and power efficiency of the VBA.

In one example, this disclosure describes a proof mass assembly including: a proof mass; a proof mass support; a flexure connecting the proof mass to the proof mass support, wherein the proof mass is configured to rotate relative to the proof mass support via the flexure; and a resonator beam connected to a first major surface of the proof mass and a first major surface of the proof mass support, the resonator beam including: a first electrode disposed on a surface of the resonator beam; and a second electrode disposed on the surface of the resonator beam, wherein the first electrode is configured to have an opposite charge than that of the second electrode, wherein the resonator beam comprises a gap between the first electrode and the second electrode on the surface of the resonator beam, wherein the gap is less than or equal to 250 micrometers.

In another example, this disclosure describes a method including: selective laser etching a feature into a resonator beam adjacent to a surface of the resonator beam, wherein the resonator beam comprises a piezoelectric material; depositing a conductive material onto the surface of the resonator beam adjacent to the feature, wherein a first electrode and a second electrode comprises the conductive material; and forming, via the feature, a gap within the conductive material on the surface of the resonator beam, wherein the gap electrically isolates the first electrode from the second electrode.

In another example, this disclosure describes a resonator beam including: a first electrode disposed on a surface of the resonator beam; and a second electrode disposed on the surface of the resonator beam, wherein the first electrode is configured to have an opposite charge than that of the second electrode, wherein the resonator beam comprises a gap between the first electrode and the second electrode on the surface of the resonator beam, wherein the gap is less than or equal to 250 micrometers, wherein the resonator beam is configured to be connected to a first major surface of a proof mass and a first major surface of a proof mass support.

The details of one or more examples are set forth in the accompanying drawings and the description below. Other features, objects, and advantages will be apparent from the description and drawings, and from the claims.

### BRIEF DESCRIPTION OF THE FIGURES

FIG. 1A is a conceptual diagram illustrating a top view of an example proof mass assembly.
FIG. 1B is a conceptual diagram illustrating a cross-sectional side view of the example proof mass assembly of FIG. 1A along line AA-AA.
FIG. 2 is a conceptual diagram illustrating an enlarged top view of an example resonator.
FIGS. 3 is a conceptual diagram illustrating an enlarged side view of an example proof mass assembly.
FIG. 4 is a conceptual diagram illustrating an enlarged perspective view of an example resonator including electrodes.
FIG. 5 is a flow diagram illustrating an example technique of making a proof mass assembly.
FIGS. 6A-6C are a series of conceptual diagrams illustrating side views of a portion of an example resonator beam at various stages of forming a gap in a conductor disposed on a surface of the beam.
FIGS. 7A-7C are a series of conceptual diagrams illustrating side views of a portion of another example resonator beam at various stages of forming a gap in a conductor disposed on a surface of the beam.
FIGS. 8A-8B are a series of conceptual diagrams illustrating side views of a portion of another example resonator beam at various stages of forming a gap in a conductor disposed on a surface of the beam.
FIG. 9 is a block diagram illustrating an accelerometer system.

### DETAILED DESCRIPTION

Navigation systems and positioning systems rely on the accuracy of accelerometers, such as vibrating beam accelerometers (VBAs) to perform critical operations in various environments. VBAs use a proof mass assembly including resonators, e.g., vibrating beams, double ended tuning forks, or the like, to measure acceleration. For example, a resonator may determine the displacement of a proof mass with a high degree of accuracy from which an acceleration experienced by the VBA may be determined.

Resonators utilizing beams, also referred to as tines, made of a piezo-electric material use electrodes on surfaces of the beams to drive the piezo-electric beams into resonance. For example, opposing surfaces of the resonator beams may have electrodes configured to have opposite charge spatially aligned across from each other. In order to form electrodes having a desired surface area coverage (e.g., a desired electrode pattern on surfaces of the resonator beams) such that the electrodes may drive the resonator beams, a conductive material is patterned on the surfaces of the beams. In particular, the sidewalls (vertical surfaces) of piezo-electric resonator beams are patterned with conductive material to form electrodes to effectively drive the piezo-electric material into resonance.

For example, the resonator beams may include a patterned conductive material forming two separate electrodes. The two electrodes may be formed by electrically isolating, or separating, conductive material disposed on surfaces of the beams, and the performance of a VBA may depend on the patterning. For example, the smaller the spaces between the electrodes on the vertical sidewalls, the better the accelerometer performance. Reducing the size of gaps between resonator beam electrodes may improve the Q factor of the resonator and the efficiency of driving the resonator beams.

Patterning of conductive material, such as a metal, on the sidewalls (vertical surfaces) of a piezo-electric resonator may use aperture or shadow masks or laser ablation. Methods using aperture or shadow masks often requires multiple metal depositions and has inherent limitations regarding the size of the features that can be achieved. Laser ablation is expensive and requires that metal patterns on both vertical resonator surfaces to be identical. Other techniques, such as focused ion beam (FIB), are cost prohibitive

The sidewalls (vertical surfaces) are particularly challenging to pattern with electrodes using the methods noted above. There is limited space between the resonator beams of a double ended tuning fork that limits the line of sight to the sidewall surfaces to include only oblique angles, which increases the difficulty for any or all of coating the conductive material on the surface, using aperture masks, or ablating the material of, or on, the sidewalls.

In accordance with the systems, devices, and techniques disclosed herein, a VBA resonator beam includes first and second electrodes disposed on a surface of the resonator beam and separated by a reduced gap. The electrodes including the reduced gap may be formed via selective laser etch (SLE). SLE is not subject to the same constraints as other methods of patterning electrodes on a surface, and such a reduced gap may be a gap that is reduced relative to other methods of forming the electrodes, and may be a gap that is less than or equal to 250 micrometers.

For example, SLE may utilize laser radiation for which a material is substantially transparent unless the light has a sufficient energy density (e.g., achieved by focusing and/or pulsing the light) and may be performed through the material and at a particular depth. As such, SLE may not have the same line of sight or oblique angle constraints. In some examples, resonator beam electrodes may be patterned on the sidewalls of a resonator beam using SLE through the other resonator beam of a DETF resonator. The interaction of the laser light of the SLE may be depth controlled by controlling the depth at which the laser light has a threshold energy density to interact with a material, which may be done by controlling the depth at which the laser light is focused. For example, SLE may be used to selectively damage molecular bonds of a material in a very localized volume, and the location of the volume may be controlled to form a spatial pattern over a larger area or volume. Additionally, SLE may have a higher resolution that that of other techniques. For example, SLE may achieve a small focus, e.g., a smaller, or finer, spatial extent of laser light reaching the energy density sufficient to interact with the material, e.g., damage molecular bonds. Additionally, SLE is a cost-effective patterning technique.

In some examples, a pattern may be selective laser etched into the material of the resonator beam before disposing a conductive material onto the resonator beam such that when the conductive material is disposed onto a surface of the resonator beam, the patterned first and second electrodes including the reduced gap is formed. For example, SLE may be used to create in-situ features to define metal deposition on a surface of a resonator beam, e.g., forming an effective aperture or shadow mask, or micro-mask, from the material of the resonator beam itself. Such features may be left, or may then be subsequently removed.

Alternatively, the first and second electrodes including the reduced gap may be formed after the conductive material is disposed on a surface of the resonator beam. For example, the material of the resonator beam may be etched via SLE to remove a portion of the underlying resonator beam material to remove the conductive material to form the reduced gap.

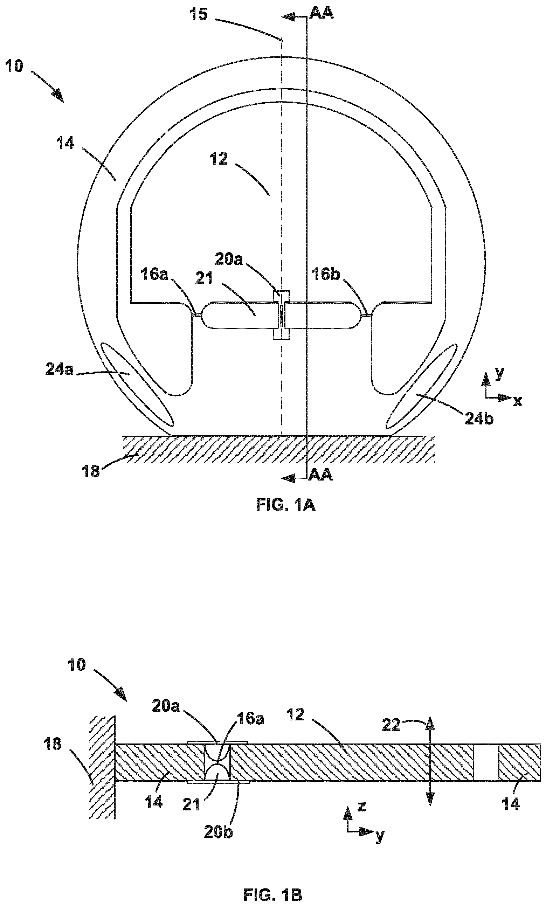

FIGS. 1A and 1B are conceptual diagrams illustrating a top view (FIG. 1A) and a cross-sectional side view (FIG. 1B, taken along line AA-AA of FIG. 1A) of an example proof mass assembly 10 that includes a proof mass 12 connected to proof mass support 14 by flexures 16a and 16b. Proof mass assembly 10 also includes at least two resonators 20a and 20b bridging a space 21 between proof mass 12 and proof mass support 14. Resonators 20a and 20b (collectively "resonators 20") each have opposing ends connected to, integral with, mounted to, and/or attached to proof mass 12 and proof mass support 14, respectively. Proof mass assembly 10 may be a proof mass assembly of a VBA.

VBAs operate by monitoring the differential change in frequencies between resonators 20a and 20b. Each of resonators 20a and 20b, also referred to as double ended tuning forks (DETFs), will vibrate at a certain frequency depending on the resonator tine geometry, and material properties such as density and elastic modulus. The resonator is configured to change frequency as a function of the axial load or force (e.g., compression or tension exerted in the y-axis direction of FIGS. 1A and 1B) exerted on the respective resonator 20a or 20b. During operation, proof mass support 14 may be directly or indirectly mounted to an object 18 (e.g., aircraft, missile, orientation module, etc.) that undergoes acceleration or angle change and causes proof mass 12 to experience inertial displacements in a direction perpendicular to the plane defined by flexures 16a and 16b (e.g., in the direction of arrows 22 or in the direction of the z-axis of FIG. 1B). The deflection of proof mass 12 induces axial tension on one of resonators 20a and 20b and axial compression on the other depending on the direction of the force. The different relative forces on resonators 20a and 20b will alter the respective vibration frequencies of the resonators 20a and 20b. By measuring these changes, the direction and magnitude of the force exerted on object 18, and thus the acceleration, can be measured.

Proof mass assembly 10 may include additional components, such as strain isolators, thermal isolators, or components that are used to enhance an oscillating frequency across resonators 20a and 20b such as one or more electrical traces, piezoelectric drivers, electrodes, and the like, or other components that may be used with the final construction of the accelerometer such as stators, permanent magnets, capacitance pick-off plates, dampening plates, force-rebalance coils, and the like, which are not shown in FIGS. 1A and 1B. Such components may be incorporated on proof mass assembly 10 or the final accelerometer.

As shown in FIG. 1A, proof mass support 14 may be a planar ring structure that substantially surrounds proof mass 12 and substantially maintains flexures 16a and 16b and proof mass 12 in a common plane (e.g., the x-y plane of FIGS. 1A and 1B). Although proof mass support 14 as shown in FIG. 1A is a circular shape, it is contemplated that proof mass support 14 may be any shape (e.g., square, rectangular, oval, or the like) and may or may not surround proof mass 12.

Proof mass 12, proof mass support 14, and flexures 16 may be formed using any suitable material. In some examples, any or all of proof mass 12, proof mass support 14, and flexures 16 may be made of one or more optically transparent materials, e.g., a material or materials that are substantially transparent for light in the ultraviolet, visible, near infrared, midwave infrared, or far infrared wavelength ranges (e.g., from a 0.1 micrometer wavelength to 10 micrometer wavelength). In some examples, proof mass 12, proof mass support 14, and flexures 16 may be made of quartz, crystalline quartz, or any suitable material, e.g., one or more materials that are substantially transparent to SLE light. In some examples, proof mass 12, proof mass support 14, and flexures 16 may be made of the same material, e.g., crystalline quartz. In other examples, proof mass 12, proof mass support 14, and flexures 16 may be made of different materials having substantially the same CTE and assembled and/or attached.

In some examples, resonators 20a and 20b may be made of one or more optically transparent materials, e.g., a material or materials that are substantially transparent for light in the ultraviolet, visible, near infrared, midwave infrared, or far infrared wavelength ranges (e.g., from a 0.1 micrometer wavelength to 10 micrometer wavelength). Resonators 20a and 20b may be made of any suitable material that is substantially transparent to SLE light. In some examples, resonators 20a and 20b are made of a piezoelectric material, such as quartz (SiOz), Berlinite (AlPO₄), gallium orthophosphate (GaPO₄), thermaline, barium titanate (BaTiO₃), lead zirconate titanate (PZT), zinc oxide (ZnO), or aluminum nitride (AlN), or the like.

In some examples, resonators 20a and 20b may comprise the same material as proof mass 12, proof mass support 14, and flexures 16, and attached and/or assembled with proof mass 12, proof mass support 14, and flexures 16, e.g., via laser welding. In other examples, resonators 20a and 20b may comprise different materials from each other and/or proof mass 12, proof mass support 14, and flexures 16, and may be attached and/or assembled with proof mass 12, proof mass support 14, and flexures 16. For example, resonators 20a and 20b may comprise a material different from proof mass 12, proof mass support 14, and flexures 16, and having substantially the same CTE proof mass 12, proof mass support 14, and flexures 16.

In some examples, resonators 20a and 20b, proof mass 12, proof mass support 14, and flexures 16 may have substantially the same CTE. In some examples, proof mass assembly 10 may comprise additional components (not shown) having substantially the same CTE as with resonators 20a and 20b, proof mass 12, proof mass support 14, and flexures 16, e.g., strain isolators, thermal isolators, dampening plates, or the like, and attached and/or assembled without the use of other materials, e.g., adhesives, epoxies, or the like. In some examples, such additional components may be made of the same material as resonators 20a and 20b, proof mass 12, proof mass support 14, and flexures 16.

In some examples, resonators 20a and 20b may comprises resonator beams, or tines, comprising electrodes. The electrodes may be patterned and configured to drive the resonator beams into resonance. The electrodes may be disposed on a vertical surface of a resonator beam, and may include a reduced gap between the electrodes, e.g., a gap that is less than or equal to 250 micrometers. The electrodes including the reduced gap may be formed using SLE.

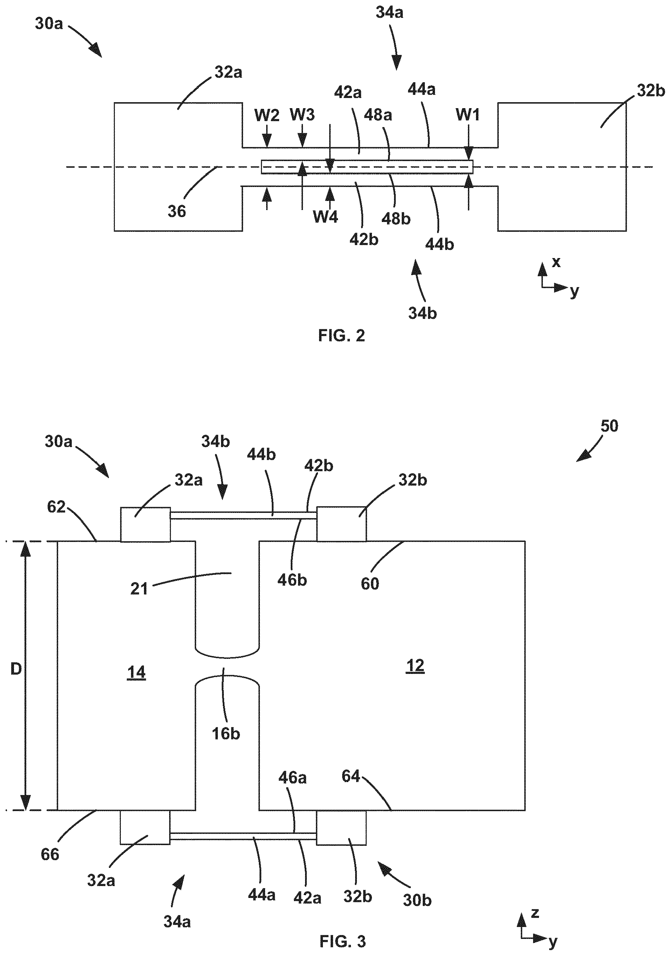

FIG. 2 is an enlarged schematic top view of an example resonator 30a that includes a first and second pads 32a and 32b positioned at opposite ends of two elongated resonator beams 34a and 34b that extend parallel to each other along a longitudinal axis 36 and separated by a width W1 for at least a portion of their length along longitudinal axis 36. In the example, shown, elongated tine 34a may have a width W3 and elongated tine 34b may have a width W4, and at least a portion of the length of resonator 30a along longitudinal axis 36 has a width W2. In some examples, W3 may be substantially the same as W4. As described above, resonator 30a may be referred to as a DETF. In some examples, resonator 30a may be substantially the same as resonator 20a and/or resonator 20b of FIG. 1.

First and second pads 32a and 32b of resonator 30a may be attached to, or integrally formed with, proof mass 12 and/or proof mass support 14, respectively. Resonator beams 34a and 324b may be attached to, or integrally formed with, resonator pads 32a and 32b, respectively. Resonator beams 34a and 34b may have a cylindrical shape, a rectangular shape, a square shape, an I-beam shape, or any suitable shape e.g., any suitable cross-sectional shape and extending in the longitudinal direction (the y-direction as shown). Resonator beams 34a and 34b may be hollow or solid. In some examples, resonator beams 34a and 34b may have a substantially rectangular or square cross-sectional shape. For example, resonator beams 34a and 34b may each have a top surface 42a and 42b, respectively, that is facing away from proof mass support 14 and/or proof mass 12, an outer sidewall (or vertical) surface 44a and 44b, respectively, a bottom surface 46a and 46b, respectively, that is facing towards proof mass support 14 and/or proof mass 12, and an inner sidewall (or vertical) surface 48a and 48b, respectively. Vertical surfaces 44a, 44b, 48a, and 48b may be parallel to a direction of motion of proof mass 12 (e.g., the z-direction), and top surfaces 42a, 42b and bottom surfaces 46a, 46b may be perpendicular to a direction of motion of proof mass 12. Electrodes may be formed and/or pattered onto any of the surface of first and second pads 32a, 32b, or surfaces 42a, 42b, 44a, 44b, 46a, 46b, 48a, or 48b.

FIG. 3 is conceptual diagrams illustrating a cross-sectional side view of an example proof mass assembly 50 that includes a proof mass 12 connected to proof mass support 14 by flexures 16a and 16b. Proof mass assembly 50 may be substantially similar to proof mass assembly 10. The cross-sectional view of FIG. 3 is taken along line AA-AA similar to as in FIG. 1A. Resonators 30a and 30b (collectively "resonators 30") may be substantially similar to resonator 30a of FIG. 2. In some examples, proof mass assembly 50 may also include damping plates (not shown) connected to proof mass support 14. Resonators 30a and 30b of proof mass assembly 50 may bridge space 21 between proof mass 12 and proof mass support 14. Resonators 30a and 30b each have opposing ends connected to, integral with, mounted to, and/or attached to proof mass 12 and proof mass support 14, respectively. Proof mass assembly 50 may be a proof mass assembly of a VBA.

In the example shown, resonator 30a is connected to surface 60 of proof mass 12 and surface 62 of proof mass support 14. Surfaces 60 and 62 may be major surfaces of proof mass 12 and proof mass support 14, respectively, e.g., top-side surfaces. Resonator 30b is connected to surface 64 of proof mass 12 and surface 66 of proof mass support 14. Surfaces 64 and 66 may be major surfaces of proof mass 12 and proof mass support 14, respectively, e.g., bottom-side surfaces. In the example shown, top surface 60 of proof mass 12 is opposite bottom surface 64, and top surface 62 of proof mass support 14 is opposite bottom surface 64. In the example shown, pads 32a, 32b are configured to connect and offset tines 34a, 34b, from proof mass support 14 and proof mass 12, e.g., in the z-direction, e.g., the depth direction. For example, resonators 30a and 30b are not coplanar with each other, proof mass support 14 and proof mass 12, e.g., resonators 30a and 30b are offset in the depth direction, e.g., the z-direction, from the thickness D (e.g., length D in the depth direction) of proof mass 12 and proof mass support 14. In the example shown, proof mass 12 and proof mass support 14 have the same thickness D. In other examples, proof mass 12 and proof mass support 14 may have different thicknesses, which may differ from the thicknesses of resonators 30a and 30b.

In some examples, resonators 30a and 30b may be offset relative to each other, e.g., from a center line of proof mass assembly 50 in the x-direction (not shown in FIG. 3). For example, and in reference to FIG. 1A, although resonators 20 are illustrated as being located at center line 15 of proof mass assembly 10, e.g., along the x-direction in FIG. 1A, in some examples resonator 20a is offset and/or displaced relative to resonator 20b along the x-direction. For example, resonator 20a may be connected to "top" surfaces of proof mass 12 and proof mass support 14 and offset in the x-direction relative to resonator 20b connected to the opposing "bottom" surfaces of proof mass 12 and proof mass support 14, e.g., resonator 20a may be located left of center line 15 and resonator 20b may be located right of center line 15. Similarly, resonator 30a may be offset and/or displaced relative to resonator 30b along the x-direction of proof mass assembly 50.

In some examples, proof mass 12 is configured to rotate relative to proof mass support 14 via flexures 16a and/or 16b, e.g., in the y-z plane. In some examples, proof mass assembly 50 includes top damping plate and bottom damping plate (not shown). Damping plates may be connected to proof mass support 14 and may be configured to limit a range of rotation, motion, and/or displacement of proof mass 12.

In some examples, resonators 30a and 30b are configured to have opposite compressive/tensile forces upon rotation of proof mass 12 in a particular direction in the y-z plane. For example, resonator 30a is connected to top surface 60 of proof mass 12 and top surface 62 of proof mass support 14 and is configured to have a tensile force upon "downward" rotation of proof mass 12, e.g., in the negative z-direction in the example shown. Resonator 30b is connected to bottom surface 64 of proof mass 12 and bottom surface 66 of proof mass support 14 and is configured to have a compressive force upon such downward rotation of proof mass 12. Upon upward rotation of proof mass 12, e.g., in the positive z-direction in the example shown, resonator 30a is configured to have a compressive force and resonator 30b is configured to have a tensile force. The compressive and tensile forces of resonators 30a and 30b change the resonant frequency of tines 34a, 34b from which a VBA including proof mass assembly 50 may determine a direction (e.g., up or down in the example shown) and an acceleration and/or motion of proof mass 12.

In some examples, proof mass assembly 50 may include one or more strain isolators (not shown) and one or more thermal isolators (not shown).

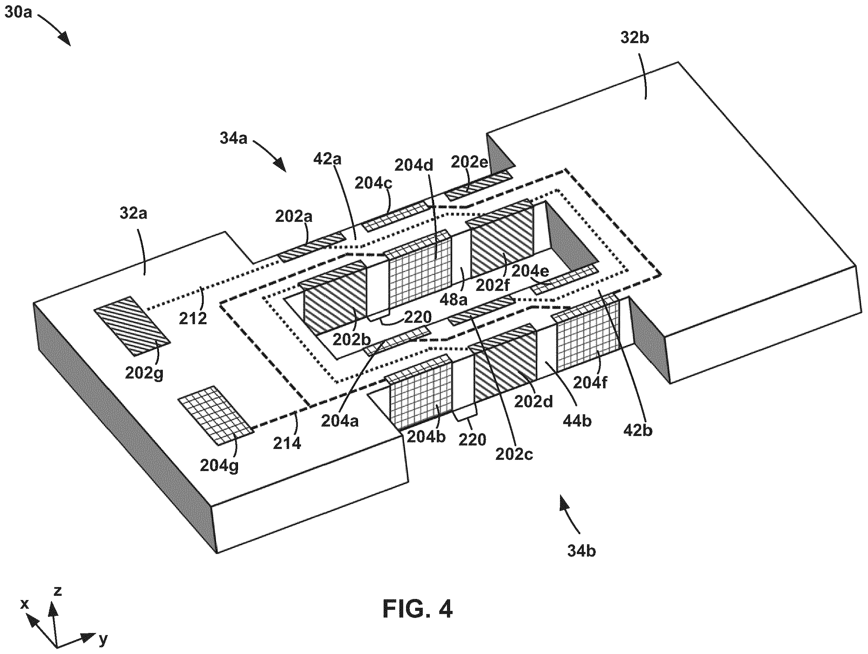

FIG. 4 is a conceptual diagram illustrating an enlarged perspective view of an example resonator 30a including electrodes 202 and 204. Resonator 30a may be substantially similar to resonator 30a of FIG. 2 and/or resonator 20a of FIG. 1. Resonator 30a includes first and second pads 32a and 32b positioned at opposite ends of two elongated resonator beams 34a and 34b that extend parallel to each other, as described above with reference to FIG. 2.

First and second pads 32a and 32b and resonator beams 34a and 34b may be formed of a piezo-electric material such as quartz. Resonator beams 34a and 34b may be configured to be driven at one or more resonances by electrodes 202 and 204. Electrodes 202 and 204 may be disposed on any or all of first and second pads 32a and 32b and resonator beams 34a and 34b in a pattern. In the example shown, electrode 202 is disposed on the top surface of first pad 32a and surfaces 42a, 44a (not shown), 46a (not shown) and 48a of resonator beam 34a and surfaces 42b, 44b, 46b (not shown), and 48b (not shown) of resonator beam 34b, in an electrode pattern including surface areas 202a-202g. Similarly, electrode 204 is disposed on the top surface of first pad 32a and surfaces 42a, 44a (not shown), 46a (not shown) and 48a of resonator beam 34a and surfaces 42b, 44b, 46b (not shown), and 48b (not shown) of resonator beam 34b, in an electrode pattern including surface areas 204a-204g. Electrode areas 202g and 204g may be contacts for providing an electrical connection to electrodes 202 and 204 of resonator 30a. Electrode areas 202a-202g are electrically connected to each other by electrical traces 212, and electrode areas 204a-204g are electrically connected to each other by electrical traces 214. In some examples, electrical traces 212 and 214 may be additional electrode areas of patterned electrodes 202 and 204, respectively.

In the example shown, electrode area 202g is electrically connected to electrode area 202a via electrical trace 212, which may be disposed on surfaces 42a, 44a (not shown), and 46a (not shown) of resonator beam 34a at a first longitudinal position along the length (in the y-direction) of resonator beams 34a, 34b. For example, electrode area 202a may be disposed on a portion of the top, outer sidewall, and bottom surfaces of resonator beam 34a. Electrode area 202a may be electrically connected to electrode area 202b via electrical trace 212 disposed on a surface 46a (bottom surface, not shown) of resonator beam 34a and at the first longitudinal position. Electrode area 202b may be disposed on surfaces 42a, 46a (not shown), and 48a of resonator beam 34a. For example, electrode area 202b may be disposed on a portion of the top, inner sidewall, and bottom surfaces of resonator beam 34a. Electrode area 202f may be similarly disposed on surfaces 42a, 46a, and 48a as electrode area 202b, only at a second longitudinal position (in the y-direction) of resonator beams 34a, 34b. Electrode area 202e may be similarly disposed on surfaces 42a, 46a, and 44a as electrode area 202a, but at the second longitudinal position (in the y-direction) of resonator beams 34a, 34b. Electrode area 202f may be electrically connected to electrode area 202a via electrical trace 212 on surface 42a, and electrode area 202e may be elect connected to electrode area 202f via electrical trace 212 on surface 46a (not shown). Electrode area 202c may be electrically connected to electrode area 202f via electrical trace 212 disposed on surface 42a of resonator beam 34a, the top surface of second pad 32b, and surface 42b of resonator beam 34b, and electrode area 202c may be disposed on surfaces 42b, 48b (not shown), and 46b (not shown) of resonator beam 34b, and at a third longitudinal position along the length of resonator beams 34a, 34b, e.g., between the first and second longitudinal positions. For example, electrode area 202c may be disposed on a portion of the top, inner sidewall, and bottom surfaces of resonator beam 34b at the third longitudinal position between the first and second longitudinal positions. Electrode area 202d may be disposed on surfaces 42b, 44b, and 46b (not shown) of resonator beam 34b, e.g., the top, outer sidewall, and bottom surfaces of resonator beam 34b. Electrode area 202d may be electrically connected to electrode area 202b via electrical trace 212 disposed on surface 42b of resonator beam 34b, the top surface of first pad 32a, and surface 42a of resonator beam 34a.

In the example shown, electrode area 204g is electrically connected to electrode area 204a via electrical trace 214, which may be disposed on surfaces 42b, 48b (not shown), and 46b (not shown) of resonator beam 34b at the first longitudinal position along the length (in the y-direction) of resonator beams 34a, 34b. For example, electrode area 204a may be disposed on a portion of the top, inner sidewall, and bottom surfaces of resonator beam 34b. Electrode area 204a may be electrically connected to electrode area 204b via electrical trace 214 disposed on a surface 46b (bottom surface, not shown) of resonator beam 34b and at the first longitudinal position. Electrode area 204b may be disposed on surfaces 42b, 46b (not shown), and 44b of resonator beam 34b. For example, electrode area 204b may be disposed on a portion of the top, outer sidewall, and bottom surfaces of resonator beam 34b. Electrode area 204f may be similarly disposed on surfaces 42b, 46b, and 44b as electrode area 204b, only at the second longitudinal position (in the y-direction) of resonator beams 34a, 34b. Electrode area 204e may be similarly disposed on surfaces 42a, 46a, and 48a as electrode area 204a, but at the second longitudinal position (in the y-direction) of resonator beams 34a, 34b. Electrode area 204f may be electrically connected to electrode area 204a via electrical trace 212 on surface 42b, and electrode area 204e may be elect connected to electrode area 204f via electrical trace 212 on surface 46b (not shown). Electrode area 204c may be electrically connected to electrode area 204f via electrical trace 212 disposed on surface 42b of resonator beam 34b, the top surface of second pad 32b, and surface 42a of resonator beam 34a, and electrode area 204c may be disposed on surfaces 42a, 44a (not shown), and 46a (not shown) of resonator beam 34a, and at the third longitudinal position along the length of resonator beams 34a, 34b, e.g., between the first and second longitudinal positions. For example, electrode area 204c may be disposed on a portion of the top, outer sidewall, and bottom surfaces of resonator beam 34a at the third longitudinal position between the first and second longitudinal positions. Electrode area 204d may be disposed on surfaces 42a, 48a, and 46a (not shown) of resonator beam 34a, e.g., the top, inner sidewall, and bottom surfaces of resonator beam 34a. Electrode area 204d may be electrically connected to electrode areas 204b and 204g via electrical trace 212 disposed on surface 42a of resonator beam 34a, the top surface of first pad 32a, and surface 42b of resonator beam 34b.

Electrodes 202 and 204 are patterned on the surfaces of resonator beams 34a, 34b opposing each other and may be configured to be driven with an opposite charge and at one or more driving frequencies, e.g., one or more resonant frequencies of resonator beams 34a, 34b. When an acceleration (e.g., a force) in the z-direction is applied to a proof mass assembly including resonator 30a, resonator beams 34a and 34b will be in tension or compression and the piezo-electric material of resonator beams 34a, 34b may cause a voltage gradient which may change a resonant frequency of resonator 30a. In the example shown, electrode areas 202b and 202f disposed on inner sidewall 48a of resonator beam 34a are opposite and facing electrode areas 204a and 204e disposed on inner sidewall 48b of resonator beam 34b and at the first and second longitudinal positions, respectively. Electrode area 204d is disposed on inner sidewall 48a of resonator beam 34a and is opposite and facing electrode area 202c disposed on inner sidewall 48b of resonator beam 34b at the third longitudinal position.

In the example shown, electrodes 202 and 204 may be electrically isolated from each other, and may have a reduced gap 220 between them. For example, resonator beam 34a includes a reduced gap 220 between electrode areas 202b and 204d, between electrode areas 202a and 204c, and between electrode areas 204d and 202f. Resonator beam 34b includes a reduced gap 220 between electrode areas 204c and 202e, between electrode areas 204b and 202d, between electrode areas 204a and 202c, between electrode areas 202d and 204f, and between electrode areas 202c and 204e. Reduced gap 220 may be formed via SLE and reduced gap 220 may be less than or equal to 250 micrometers. In some examples, the reduced gap 220 between two electrode areas may be the same as, or different than, the reduced gap 220 between two different electrode areas.

Although two electrodes 202 and 204 patterned to have eight electrode areas each, electrodes 202 and 204 may have fewer or more alternating and opposing electrode areas disposed on resonator beams 34a, 34b, e.g., electrode 202 may include two electrode areas, or four or more electrode areas that are alternating with and opposing two electrode areas of electrode 204, or 4 or more electrode areas of electrode 204. In some examples, electrode areas 202a-202g and 204a-204g may be considered to be eight individual and electrically connected electrodes, respectively. In some examples, resonator 30a may include electrode areas, or electrodes, more or fewer surfaces of each of resonator beams 34a, 34b. For example, resonator 30a may include only electrode areas 202b, 204d, and 202f on only inner sidewall 48a of resonator beam 34a and electrode areas 204a, 202c, and 204e on only inner sidewall 48b of resonator beam 34b, e.g., with electrode areas 202b, 202f, and 202c electrically connected to each other and electrode areas 204d, 204a, and 204e electrically connected to each other but electrically isolated from electrode areas 202b, 202f, and 202c.

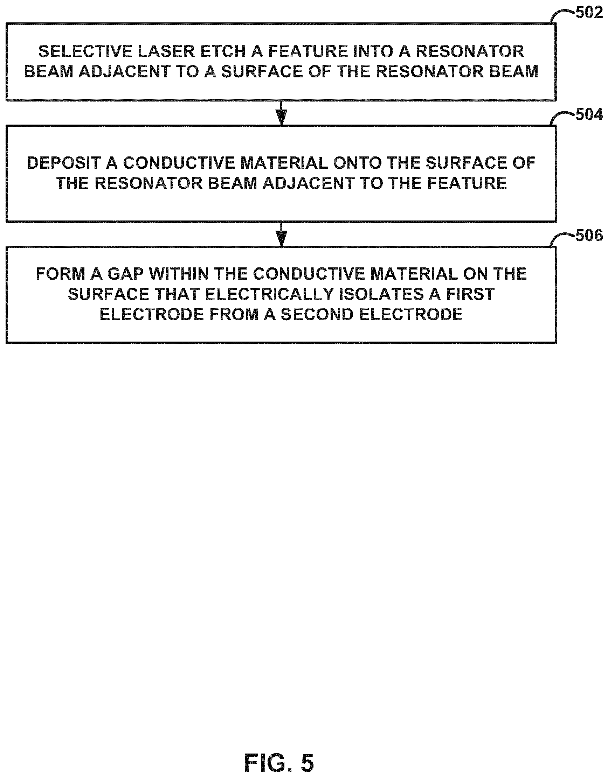

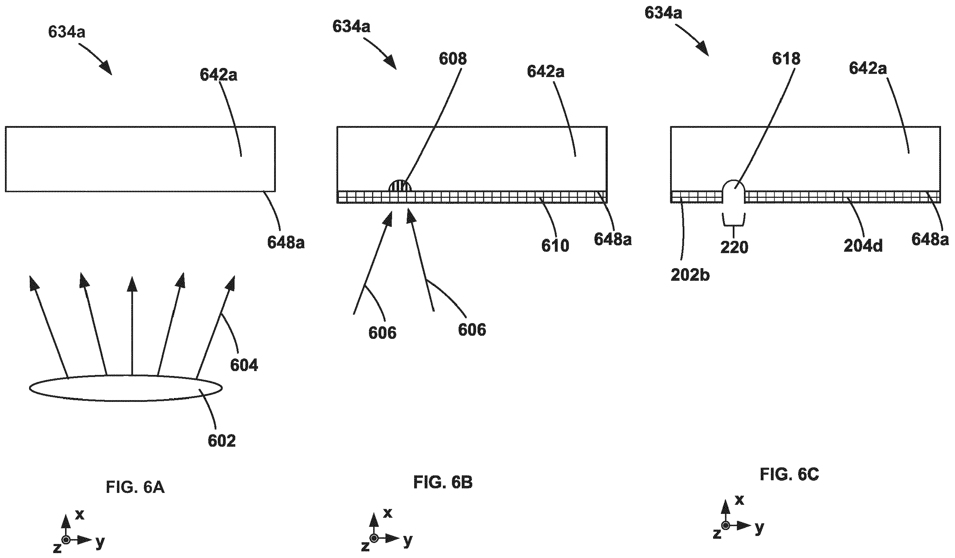

FIG. 5 is a flow diagram illustrating an example technique of making a proof mass assembly. FIG. 5 is described with respect to proof mass assembly 10 of FIGS. 1A and 1B, proof mass assembly 50 of FIG. 3, resonator 30a of FIG. 4, and resonator beams 634a, 734a, and 834a of FIGS. 6A-8B. However, the techniques of FIG. 5 may be utilized to make different proof mass assemblies and/or additional or alternative accelerometer systems.

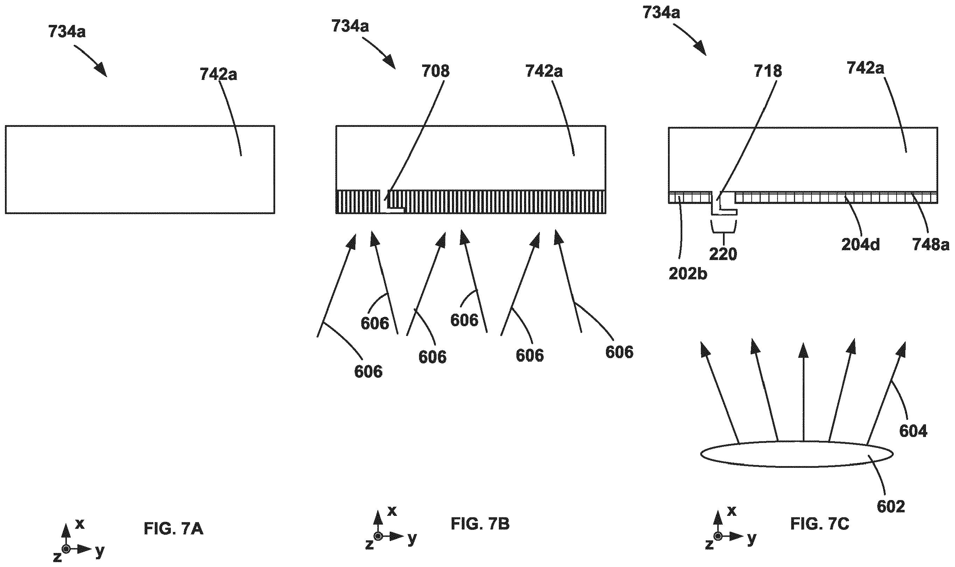

A manufacturer may selective laser etch a feature into a resonator beam 34a adjacent to a surface 48a of resonator beam 34a (502). For example, the manufacturer may selective laser etch a feature 618 (FIG. 6C), a feature 718 (FIG. 7C), or feature 818 (FIG. 8C) into resonator beams 634a, 734a, or 834a, respectively. Resonator beams 634a, 734a, and 834a may be examples of resonator beam 34a of FIG. 4 and surfaces 648a, 748a, and 848a may be examples of surface 48a of FIG. 4, but with different features selective laser etched into respective resonator beams 634a, 734a, and 834a.

The manufacturer may deposit a conductive material onto the surface 48a of resonator beam 34a adjacent to the feature (504). For example, the manufacturer may cause a conductive material source 602 (FIGS. 6A, 7C, and 8B) to provide the conductive material 604 to surface 48a (or surfaces 648a, 748a, or 848a, respectively) via coating, evaporative coating, vacuum deposition, or any suitable method for depositing and/or forming a layer of conductive material 610 (FIG. 6B) on surface 48a. First electrode 202 and second electrode 204 may comprise the conductive material.

The manufacturer may form a reduced gap 220 within the conductive material on the surface 48a of resonator beam 34a (506). Reduced gap 220 may electrically isolate electrode 202 from electrode 204.

In some examples, the manufacturer may deposit the conductive material onto surface 48a before selective laser etching the feature at (502) and forming reduced gap 220 at (506). For example, the manufacturer may cause conductive material source 602 to deposit conductive material 604 onto surface 648a (FIG. 6A) to form conductive layer 610 (FIG. 6B). FIGS. 6A-6C are a series of conceptual diagrams illustrating side views of a portion of an example resonator beam 634a at various stages of forming a reduced gap 220 in a conductor disposed on a surface 648a of the beam. As noted above, resonator beam 634a may be an example of resonator beam 34a of FIGS. 3-4, and surface 648a may be an example of inner sidewall (vertical) surface 48a of FIGS. 2-4. In some examples, conductive material 604 and conductive material layer 610 may comprise any or all of gold, silver, copper, molybdenum, chromium, graphene, tantalum, or any suitable electrically conductive material.

Once the conductive material is disposed on surface 648a at step (504) and as illustrated in FIG. 6A, the manufacturer may selective laser etch feature 618 at step (502), as illustrated in FIGS. 6B and 6C. For example, the manufacturer may focus and pulse laser light 606 to damage and/or break molecular bonds of the volume 608 of piezo-electric material of resonator beam 648a corresponding to feature 618, e.g., etched volume 608. In the example shown, etched volume 608 and feature 618 are a cylindrical shape extending in the z-direction with a substantially circular (or semicircular) cross-sectional shape in the x-y plane as shown. In other examples, etched volume 608 and feature 618 may have any suitable shape, for example, an L shape in the x-y plane that may or may not extend in the z-direction, a T shape in the x-y plane that may or may not extend in the z-direction, a triangular shape in the x-y plane that may or may not extend in the z-direction, a square shape in the x-y plane that may or may not extend in the z-direction, a rectangular shape in the x-y plane that may or may not extend in the z-direction, a spherical shape that may or may not extend in the z-direction, an elliptical shape, an elliptical cylinder shape (e.g., an elliptical shape in the x-y plane that extends in the z-direction), or any 2D shape which may or may not extend in the z-direction, or any 3D shape (such as a spherical, cubical, polygonal or non-polygonal shape).

The manufacturer may form etched volume 608 and feature 618 via SLE through one or more materials. For example, the manufacturer may form feature 608 by focusing laser light 606 through conductive material layer 610, e.g., without damaging molecular bonds or otherwise altering the material of conductive layer 610. For example, the bulk material of conductive layer 610 may be substantially transparent to SLE light, or conductive layer 610 may be deposited with a layer thickness such that it is substantially transparent to SLE light. Additionally, the manufacturer may focus the laser light 606 through a resonator beam that is parallel and adjacent to resonator beam 634a, e.g., a second resonator beam that forms a DETF with resonator beam 634a in the same manner that resonator beam 34b forms a DETF with resonator beam 34a of FIG. 4. In this way, the manufacturer may form etched volume 608 and feature 618 without having to use an oblique angle to access material of resonator beam 634a adjacent to inner, vertical sidewall 648a.

The manufacturer may then remove etched volume 608 to form feature 618. In the example shown, feature 618 is a recess that extends inwards from surface 648a into resonator beam 634a. For example, the manufacturer may use a wet process to remove a volume of material of resonator beam 634a corresponding to etched volume 608. Removing etched volume 608 also removes the portion of conductive material layer 610 deposited onto surface 648 adjacent to etched volume 608, forming reduced gap 220. In some examples, reduced gap 220 may have a gap distance of less than or equal to 250 micrometers that separates and/or electrically isolates electrode 202 from electrode 204. In the example shown, resonator beam 634a may include patterned electrodes 202 and 204 as shown in FIG. 4, and reduced gap 220 separates and/or electrically isolates electrodes 202 and 204 by separating and electrically isolating electrode areas 202b and 204d.

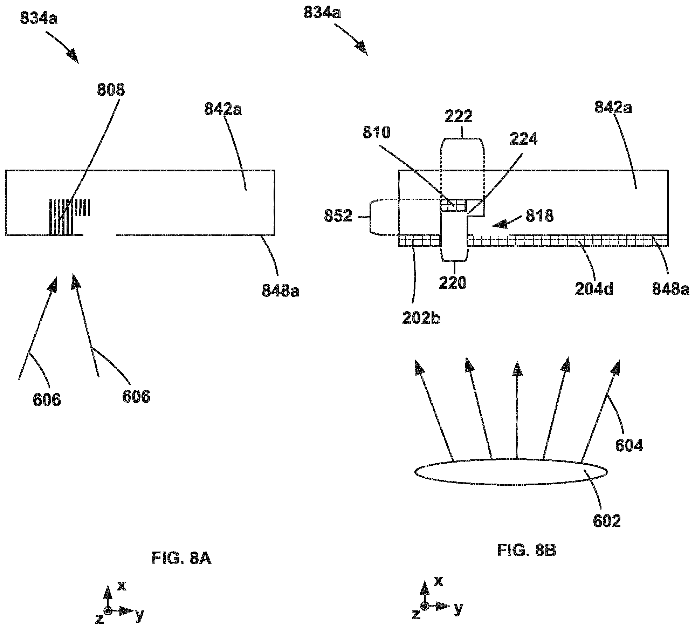

In some examples, the manufacturer may deposit the conductive material onto surface 48a after selective laser etching the feature at method step (502). For example, the manufacturer may form a protrusion in resonator beam 734A (FIGS. 7A-7C) or recess in resonator beam 834a (FIGS. 8A-8B) before depositing the conductive material onto a resonator beam surface or surfaces. FIGS. 7A-7C are a series of conceptual diagrams illustrating side views of a portion of an example resonator beam 734a at various stages of forming a reduced gap 220 in a conductor disposed on a surface 748a of the beam, and FIGS. 8A-8B are a series of conceptual diagrams illustrating side views of a portion of an example resonator beam 834a at various stages of forming a reduced gap 220 in a conductor disposed on a surface 848a of the beam. Resonator beams 734a and 834a may be an examples of resonator beam 34a of FIGS. 3-4, and surfaces 748a and 848a may be examples of inner sidewall (vertical) surface 48a of FIGS. 2-4.

In the examples shown in FIGS. 7A-7C, the manufacturer may form protrusion 718 that extends outwards from surface 748a and is configured to prevent conductive material 604 from being deposited on surface 748a in a surface area corresponding to reduced gap 220. For example, the manufacturer may selective laser etch a layer of a surface of resonator beam 734a except for an unetched volume of material 708 corresponding to feature 718 at method step (502). As shown in FIG. 7A, resonator beam 734a may have a width in the x-direction that is larger than its final designed or desired width, and the manufacturer may focus and pulse laser light 606 to damage and/or break molecular bonds of a layer or volume of piezo-electric material of resonator beam 748a except for unetched volume 708 (FIG. 7B).

In the example shown, unetched volume 708 and feature 718 are an "L" shape extending in the z-direction (e.g., a shape having an "L" shaped cross-section in the x-y plane as shown). In other examples, unetched volume 708 and feature 718 may have any suitable shape, for example, a cylindrical shape in the x-y plane that may or may not extend in the z-direction, a T shape in the x-y plane that may or may not extend in the z-direction, a triangular shape in the x-y plane that may or may not extend in the z-direction, a square shape in the x-y plane that may or may not extend in the z-direction, a rectangular shape in the x-y plane that may or may not extend in the z-direction, a spherical shape that may or may not extend in the z-direction, an elliptical shape, an elliptical cylinder shape (e.g., an elliptical shape in the x-y plane that extends in the z-direction), or any 2D shape which may or may not extend in the z-direction, or any 3D shape (such as a spherical, cubical, polygonal or non-polygonal shape).

The manufacturer may then remove the etched volume or layer to form feature 718. In the example shown, feature 718 is a protrusion that extends outwards from surface 748a and resonator beam 734a (FIG. 7C). For example, the manufacturer may use a wet process to remove a volume of material of resonator beam 734a corresponding to the etched layer or volume, while leaving unetched volume 708, which becomes feature 718, e.g., protrusion 718. In the example shown, a distal portion of feature 718 (e.g., a portion away from surface 748a in the x-direction) has a larger lateral surface area (e.g., in the y-z plane) than a base portion of feature 718 at surface 748a of resonator beam 734a.

The manufacturer may then deposit conductive material 604 onto surface 748a of resonator beam 734a at method step (504), e.g., adjacent to feature 718. Feature 718 is configured to prevent conductive material 604 from depositing on the surface area of surface 748a corresponding to reduced gap 220 (FIG. 7C). For example, feature 718 may function as an integrated lithographic mask or micromask. In some examples, feature 718 may block, shadow, or mask the area corresponding to reduced gap 220 from a direct line of sight to conductive material source 602, and block, shadow, mask, or otherwise prevent conductive material 604 from depositing on the area of surface 748a corresponding to reduced gap 220, thereby forming reduced gap 220 at method step (506), and separating and electrically isolating portions of deposited conductive material 604 to form electrode areas 202b and 204d. In some examples, the manufacturer may then subsequently remove feature 718, e.g., via SLE. In other examples, the manufacturer may leave feature 718, and resonator beam 734a may function with feature 718 present.

As mentioned above, in some examples, reduced gap 220 may have a gap distance of less than or equal to 250 micrometers that separates and/or electrically isolates electrode 202 from electrode 204. In the example shown in FIG. 7C, resonator beam 734a may include patterned electrodes 202 and 204 as shown in FIG. 4, and reduced gap 220 separates and/or electrically isolates electrodes 202 and 204 by separating and electrically isolating electrode areas 202b and 204d.

As described above with reference to FIGS. 6A-6C, the manufacturer may form unetched volume 708 and feature 718 via SLE through one or more materials, e.g., by focusing laser light 606 through a resonator beam that is parallel and adjacent to resonator beam 734a, such as a second resonator beam that forms a DETF with resonator beam 734a in the same manner that resonator beam 34b forms a DETF with resonator beam 34a of FIG. 4. In this way, the manufacturer may form unetched volume 708 and feature 718 without having to use an oblique angle to access material of resonator beam 734a adjacent to inner, vertical sidewall 748a.

In some examples, the manufacturer may form a recess in resonator beam 834A (FIGS. 8A-8B) before depositing the conductive material onto a resonator beam surface or surfaces. In the examples shown in FIGS. 8A-8B, the manufacturer may form recess 818 that extends inwards from surface 848a and is configured to prevent conductive material 604 from being in electrical connection, or contact, across reduced gap 220. For example, the manufacturer may selective laser etch a layer of a volume of material 808 of resonator beam 834a corresponding to feature 818 at method step (502). As shown in FIG. 8A, the manufacturer may focus and pulse laser light 606 to damage and/or break molecular bonds of the piezo-electric material of resonator beam 748a corresponding to etched volume 808.

In the example shown, etched volume 808 and feature 818 are an "L" shape extending in the z-direction (e.g., a shape having an "L" shaped cross-section in the x-y plane as shown). In other examples, etched volume 808 and feature 818 may have any suitable shape, for example, a cylindrical shape in the x-y plane that may or may not extend in the z-direction, a T shape in the x-y plane that may or may not extend in the z-direction, a triangular shape in the x-y plane that may or may not extend in the z-direction, a square shape in the x-y plane that may or may not extend in the z-direction, a rectangular shape in the x-y plane that may or may not extend in the z-direction, a spherical shape that may or may not extend in the z-direction, an elliptical shape, an elliptical cylinder shape (e.g., an elliptical shape in the x-y plane that extends in the z-direction), or any 2D shape which may or may not extend in the z-direction, or any 3D shape (such as a spherical, cubical, polygonal or non-polygonal shape).

The manufacturer may then remove the etched volume or layer to form feature 818. In the example shown, feature 818 is a recess that extends inwards from surface 848a and resonator beam 834a (FIG. 8C). For example, the manufacturer may use a wet process to remove a volume of material of resonator beam 834a corresponding to feature 818, e.g., recess 818. In the example shown, feature 818 comprises a first recess length in a first lateral direction (e.g., along the length or longitudinal direction of resonator beam 834a, or the y-direction, and indicated as reduced gap "width" 220 in FIG. 8B) and a first recess width in a second lateral direction (e.g., along the width direction of resonator beam 834a, or the z-direction, and not shown in the cross-section of FIG. 8B), the first recess length and first recess width corresponding to a surface area of reduced gap 220. In the example shown, feature 818 extends in a depth direction (e.g., the x-direction) into the material of resonator beam 834a to a first depth 852, wherein the recess extends laterally within the material of resonator beam 834a at the first depth 852 to a second width (not shown) that is larger than the first width (not shown) and/or a second length 222 that is larger than the first length (e.g., reduced gap "width" 220).

The manufacturer may then deposit conductive material 604 onto surface 848a of resonator beam 834a at method step (504), e.g., adjacent to feature 818. Feature 818 is configured to prevent conductive material 604 from depositing on the surface area of surface 748a corresponding to reduced gap 220 (FIG. 7B). For example, the larger lateral width and length of feature 818, being a recess, are configured to prevent electrical connection across reduced gap 220. As shown in FIG. 8B, conductive material 604 may be deposited in within feature 818, e.g., conductive material 810 at the "bottom" of the recess, and may also deposing onto the "sidewalls" of recess 818 (not shown), e.g., the surfaces of recess 818 in the x-z plane that may extend to first depth 852. Recess 818 may then have a larger lateral dimension at the bottom (e.g., at or near first depth 852) which prevent the "sidewalls" of the recess from extending to first depth 852, and prevent conductive material 604 which may be deposited onto the sidewalls from connecting to conductive material 810 deposited in the "bottom" of recess 818, e.g., the larger lateral dimensions of recess 818 within resonator beam 834a may be configured to separate conductive material forming electrode areas 202b and 204d from conductive material 810. Feature 818 may comprise a separation gap 224 configured to prevent conductive material 604 (e.g., of electrode areas 202b and 204d) from electrically connecting across reduced gap 220.

As mentioned above, in some examples, reduced gap 220 may have a gap distance of less than or equal to 250 micrometers that separates and/or electrically isolates electrode 202 from electrode 204. In the example shown in FIG. 8B, resonator beam 834a may include patterned electrodes 202 and 204 as shown in FIG. 4, and reduced gap 220 separates and/or electrically isolates electrodes 202 and 204 by separating and electrically isolating electrode areas 202b and 204d.

As described above with reference to FIGS. 6A-6C, the manufacturer may form etched volume 808 and feature 818 via SLE through one or more materials, e.g., by focusing laser light 606 through a resonator beam that is parallel and adjacent to resonator beam 834a, such as a second resonator beam that forms a DETF with resonator beam 834a in the same manner that resonator beam 34b forms a DETF with resonator beam 34a of FIG. 4. In this way, the manufacturer may form etched volume 808 and feature 818 without having to use an oblique angle to access material of resonator beam 834a adjacent to inner, vertical sidewall 848a.

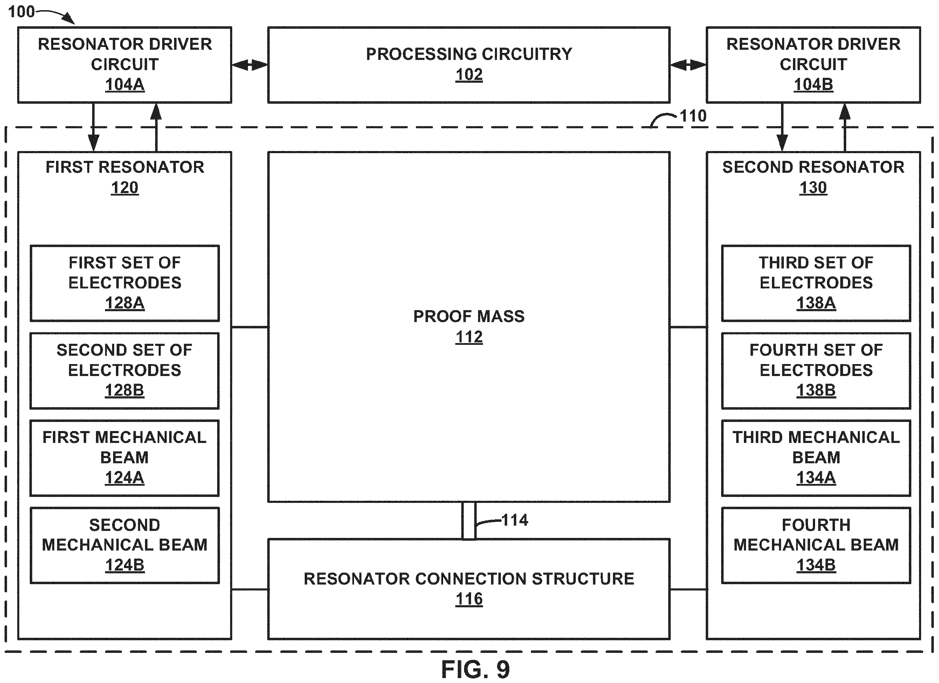

FIG. 9 is a block diagram illustrating an accelerometer system 100, in accordance with one or more techniques of this disclosure. As illustrated in FIG. 9, accelerometer system 100 includes processing circuitry 102, resonator driver circuits 104A-104B (collectively, "resonator driver circuits 104"), and proof mass assembly 110. Proof mass assembly 110 may be substantially similar to proof mass assembly 10 and/or 50 described above. Proof mass assembly 110 includes proof mass 112, resonator connection structure 116, first resonator 120, and second resonator 130. Proof mass 112 may be substantially similar to proof mass 12, resonator connection structure 116 may be substantially similar to proof mass support 14, and resonators 120, 130 may be substantially similar to resonators 20a, 20b and/or resonators 30a, 30b, described above.

First resonator 120 includes first mechanical beam 124A and second mechanical beam 124B (collectively, "mechanical beams 124"), and first set of electrodes 128A and second set of electrodes 128B (collectively, "electrodes 128"). Second resonator 130 includes third mechanical beam 134A and fourth mechanical beam 134B (collectively, "mechanical beams 134"), and third set of electrodes 138A and fourth set of electrodes 138B (collectively, "electrodes 138").

Accelerometer system 100 may, in some examples, be configured to determine an acceleration associated with an object (not illustrated in FIG. 9) based on a measured vibration frequency of one or both of first resonator 120 and second resonator 130 which are connected to proof mass 112. In some examples, the vibration of first resonator 120 and second resonator 130 is induced by drive signals emitted by resonator driver circuit 104A and resonator driver circuit 104B, respectively. In turn, first resonator 120 may output a first set of sense signals and second resonator 130 may output a second set of sense signals and processing circuitry 102 may determine an acceleration of the object based on the first set of sense signals and the second set of sense signals.

Processing circuitry 102, in some examples, may include one or more processors that are configured to implement functionality and/or process instructions for execution within accelerometer system 100. For example, processing circuitry 102 may be capable of processing instructions stored in a storage device. Processing circuitry 102 may include, for example, microprocessors, digital signal processors (DSPs), application specific integrated circuits (ASICs), field-programmable gate arrays (FPGAs), or equivalent discrete or integrated logic circuitry, or a combination of any of the foregoing devices or circuitry. Accordingly, processing circuitry 102 may include any suitable structure, whether in hardware, software, firmware, or any combination thereof, to perform the functions ascribed herein to processing circuitry 102.

A memory (not illustrated in FIG. 9) may be configured to store information within accelerometer system 100 during operation. The memory may include a computer-readable storage medium or computer-readable storage device. In some examples, the memory includes one or more of a short-term memory or a long-term memory. The memory may include, for example, random access memories (RAM), dynamic random access memories (DRAM), static random access memories (SRAM), magnetic discs, optical discs, flash memories, or forms of electrically programmable memories (EPROM) or electrically erasable and programmable memories (EEPROM). In some examples, the memory is used to store program instructions for execution by processing circuitry 102.

In some examples, resonator driver circuit 104A may be electrically coupled to first resonator 120. Resonator driver circuit 104A may output a first set of drive signals to first resonator 120, causing first resonator 120 to vibrate at a resonant frequency. Additionally, in some examples, resonator driver circuit 104A may receive a first set of sense signals from first resonator 120, where the first set of sense signals may be indicative of a mechanical vibration frequency of first resonator 120. Resonator driver circuit 104A may output the first set of sense signals to processing circuitry 102 for analysis. In some examples, the first set of sense signals may represent a stream of data such that processing circuitry 102 may determine the mechanical vibration frequency of first resonator 120 in real-time or near real-time.

In some examples, resonator driver circuit 104B may be electrically coupled to second resonator 130. Resonator driver circuit 104B may output a second set of drive signals to second resonator 130, causing second resonator 130 to vibrate at a resonant frequency. Additionally, in some examples, resonator driver circuit 104B may receive a second set of sense signals from second resonator 130, where the second set of sense signals may be indicative of a mechanical vibration frequency of first resonator 130. Resonator driver circuit 104B may output the second set of sense signals to processing circuitry 102 for analysis. In some examples, the second set of sense signals may represent a stream of data such that processing circuitry 102 may determine the mechanical vibration frequency of second resonator 130 in real-time or near real-time.

Proof mass assembly 110 may secure proof mass 112 to resonator connection structure 116 using first resonator 120 and second resonator 130. For example, proof mass 112 may be secured to resonator connection structure 116 in a first direction with hinge flexure 114. Hinge flexure 114 may be substantially similar to flexures 16a, 16b described above. Proof mass 112 may be secured to resonator connection structure 116 in a second direction with first resonator 120 and second resonator 130. Proof mass 112 may be configured to pivot about hinge flexure 114, applying force to first resonator 120 and second resonator 130 in the second direction. For example, if proof mass 112 pivots towards first resonator 120, proof mass 112 applies a compression force to first resonator 120 and applies a tension force to second resonator 130. If proof mass 112 pivots towards second resonator 130, proof mass 112 applies a tension force to first resonator 120 and applies a compression force to second resonator 130.

An acceleration of proof mass assembly 110 may affect a degree to which proof mass 112 pivots about hinge flexure 114. As such, the acceleration of proof mass assembly 110 may determine an amount of force applied to first resonator 120 and an amount of force applied to second resonator 130. An amount of force (e.g., compression force or tension force) applied to resonators 120, 130 may be correlated with an acceleration vector of proof amass assembly 110, where the acceleration vector is normal to hinge flexure 114.

In some examples, the amount of force applied to first resonator 120 may be correlated with a resonant frequency in which first resonator 120 vibrates in response to resonator driver circuit 104A outputting the first set of drive signals to first resonator 120. For example, first resonator 120 may include mechanical beams 124. In this way, first resonator 120 may represent a DETF structure, where each mechanical beam of mechanical beams 124 vibrate at the resonant frequency in response to receiving the first set of drive signals. Electrodes 128 may generate and/or receive electrical signals indicative of a mechanical vibration frequency of first mechanical beam 124A and a mechanical vibration frequency of second mechanical beam 124B. For example, the first set of electrodes 128A may generate and/or receive a first electrical signal and the second set of electrodes 128B may generate and/or receive a second electrical signal. In some examples, the first electrical signal may be in response to sensing a mechanical vibration frequency of the mechanical beams 124 (e.g., both mechanical beams 124A and 124B) via the first set of electrodes 128A, e.g., a resonant frequency of mechanical beams 124. Resonant driver circuit 104A may receive the first electrical signal and may amplify the first electrical signal to generate the second electrical signal. The second electrical signal may be applied to mechanical beams 124 (e.g., both mechanical beams 124A and 124B) via second set of electrodes 128B, e.g., to drive mechanical beams 124 to vibrate at the resonant frequency. Electrodes 128 may output the first electrical signal and the second electrical signal to processing circuitry 102. Electrodes 128 may be examples of electrodes 202 and 204 of resonators 20a, 30a, described above.

In some examples, the mechanical vibration frequency of the first mechanical beam 124A and the second mechanical beam 124B are substantially the same when resonator driver circuit 104A outputs the first set of drive signals to first resonator 120. For example, the mechanical vibration frequency of first mechanical beam 124A and the mechanical vibration frequency of second mechanical beam 124B may both represent the resonant frequency of first resonator 120, where the resonant frequency is correlated with an amount of force applied to first resonator 120 by proof mass 112. The amount of force that proof mass 112 applies to first resonator 120 may be correlated with an acceleration of proof mass assembly 110 relative to a long axis of resonator connection structure 116. As such, processing circuitry 102 may calculate the acceleration of proof mass 112 relative to the long axis of resonator connection structure 116 based on the detected mechanical vibration frequency of mechanical beams 124.

In some examples, the amount of force applied to second resonator 130 may be correlated with a resonant frequency in which second resonator 130 vibrates in response to resonator driver circuit 104B outputting the second set of drive signals to second resonator 130. For example, second resonator 130 may include mechanical beams 134. In this way, second resonator 130 may represent a DETF structure, where each mechanical beam of mechanical beams 134 vibrate at the resonant frequency in response to receiving the second set of drive signals. Electrodes 138 may generate and/or receive electrical signals indicative of a mechanical vibration frequency of third mechanical beam 134A and a mechanical vibration frequency of fourth mechanical beam 134B. For example, the third set of electrodes 138A may generate and/or receive a third electrical signal and the fourth set of electrodes 138B may generate a fourth electrical signal. In some examples, the third electrical signal may be in response to sensing a mechanical vibration frequency of the mechanical beams 134 (e.g., both mechanical beams 134A and 134B) via the third set of electrodes 138A, e.g., a resonant frequency of mechanical beams 134. Resonant driver circuit 104B may receive the third electrical signal and may amplify the third electrical signal to generate the fourth electrical signal. The fourth electrical signal may be applied to mechanical beams 134 (e.g., both mechanical beams 134A and 134B) via fourth set of electrodes 138B, e.g., to drive mechanical beams 134 to vibrate at the resonant frequency. Electrodes 138 may output the third electrical signal and the fourth electrical signal to processing circuitry 102. Electrodes 138 may be examples of electrodes 202 and 204 of resonators 20b, 30b, described above.

In some examples, the mechanical vibration frequency of the third mechanical beam 134A and the fourth mechanical beam 134B are substantially the same when resonator driver circuit 104B outputs the second set of drive signals to second resonator 130. For example, the mechanical vibration frequency of third mechanical beam 134A and the mechanical vibration frequency of fourth mechanical beam 134B may both represent the resonant frequency of second resonator 130, where the resonant frequency is correlated with an amount of force applied to second resonator 130 by proof mass 112. The amount of force that proof mass 112 applies to second resonator 130 may be correlated with an acceleration of proof mass assembly 110 relative to a long axis of resonator connection structure 116. As such, processing circuitry 102 may calculate the acceleration of proof mass 112 relative to the long axis of resonator connection structure 116 based on the detected mechanical vibration frequency of mechanical beams 134.

In some cases, processing circuitry 102 may calculate an acceleration of proof mass assembly 110 relative to the long axis of resonator connection structure 116 based on a difference between the detected mechanical vibration frequency of mechanical beams 124 and the detected mechanical vibration frequency of mechanical beams 134. When proof mass assembly 110 accelerates in a first direction along the long axis of resonator connection structure 116, proof mass 112 pivots towards first resonator 120, causing proof mass 112 to apply a compression force to first resonator 120 and apply a tension force to second resonator 130. When proof mass assembly 110 accelerates in a second direction along the long axis of resonator connection structure 116, proof mass 112 pivots towards second resonator 130, causing proof mass 112 to apply a tension force to first resonator 120 and apply a compression force to second resonator 130. A resonant frequency of a resonator which is applied a first compression force may be greater than a resonant frequency of the resonator which is applied a second compression force, when the first compression force is less than the second compression force. A resonant frequency of a resonator which is applied a first tension force may be greater than a resonant frequency of the resonator which is applied a second tension force, when the first tension force is greater than the second tension force.

Although accelerometer system 100 is illustrated as including resonator connection structure 116, in some examples not illustrated in FIG. 9, proof mass 112, first resonator 120, and second resonator 130 are not connected to a resonator connection structure. In some such examples, proof mass 112, first resonator 120, and second resonator 130 are connected to a substrate. For example, hinge flexure 114 may fix proof mass 112 to the substrate such that proof mass 112 may pivot about hinge flexure 114, exerting tension forces and/or compression forces on first resonator 120 and second resonator 130.

Although accelerometer system 100 is described as having two resonators, in other examples not illustrated in FIG. 1, an accelerometer system may include less than two resonators or greater than two resonators. For example, an accelerometer system may include one resonator. Another accelerometer system may include four resonators.

In one or more examples, the accelerometers described herein may utilize hardware, software, firmware, or any combination thereof for achieving the functions described. Those functions implemented in software may be stored on or transmitted over, as one or more instructions or code, a computer-readable medium and executed by a hardware-based processing unit. Computer-readable media may include computer-readable storage media, which corresponds to a tangible medium such as data storage media, or communication media including any medium that facilitates transfer of a computer program from one place to another, e.g., according to a communication protocol. In this manner, computer-readable media generally may correspond to (1) tangible computer-readable storage media which is non-transitory or (2) a communication medium such as a signal or carrier wave. Data storage media may be any available media that can be accessed by one or more computers or one or more processors to retrieve instructions, code and/or data structures for implementation of the techniques described in this disclosure.

Instructions may be executed by one or more processors within the accelerometer or communicatively coupled to the accelerometer. The one or more processors may, for example, include one or more DSPs, general purpose microprocessors, application specific integrated circuits ASICs, FPGAs, or other equivalent integrated or discrete logic circuitry. Accordingly, the term "processor," as used herein may refer to any of the foregoing structure or any other structure suitable for implementation of the techniques described herein. In addition, in some aspects, the functionality described herein may be provided within dedicated hardware and/or software modules configured for performing the techniques described herein. Also, the techniques could be fully implemented in one or more circuits or logic elements.

The techniques of this disclosure may be implemented in a wide variety of devices or apparatuses that include integrated circuits (ICs) or sets of ICs (e.g., chip sets). Various components, modules, or units are described in this disclosure to emphasize functional aspects of devices configured to perform the disclosed techniques, but do not necessarily require realization by different hardware units. Rather, various units may be combined or provided by a collection of interoperative hardware units, including one or more processors as described above, in conjunction with suitable software and/or firmware.

This disclosure includes the following non-limiting examples.

Example 1. A proof mass assembly comprising: a proof mass; a proof mass support; a flexure connecting the proof mass to the proof mass support, wherein the proof mass is configured to rotate relative to the proof mass support via the flexure; and a resonator beam connected to a first major surface of the proof mass and a first major surface of the proof mass support, the resonator beam comprising: a first electrode disposed on a surface of the resonator beam; and a second electrode disposed on the surface of the resonator beam, wherein the first electrode is configured to have an opposite charge than that of the second electrode, wherein the resonator beam comprises a gap between the first electrode and the second electrode on the surface of the resonator beam, wherein the gap is less than or equal to 250 micrometers.

Example 2. The proof mass assembly of example 1, wherein the surface of the resonator beam is a vertical surface of the resonator beam.

Example 3. The proof mass assembly of example 1 or example 2, wherein the surface is a first surface and the gap is a first gap, wherein the first and second electrodes are disposed on a second surface of the resonator beam that is perpendicular to the first surface; wherein the resonator beam comprises a second gap between the first electrode and the second electrode on the second surface of the resonator beam, wherein the second gap is less than or equal to 250 micrometers.

Example 4. The proof mass assembly of any one of examples 1 through 3, wherein the gap is formed via laser selective etch.

Example 5. The proof mass assembly of any one of examples 1 through 4, wherein the resonator beam comprises a piezoelectric material.

Example 6. A method comprising: selective laser etching a feature into a resonator beam adjacent to a surface of the resonator beam, wherein the resonator beam comprises a piezoelectric material; depositing a conductive material onto the surface of the resonator beam adjacent to the feature, wherein a first electrode and a second electrode comprises the conductive material; and forming, via the feature, a gap within the conductive material on the surface of the resonator beam, wherein the gap electrically isolates the first electrode from the second electrode.

Example 7. The method of example 6, wherein the feature comprises a protrusion outwards from the surface of the resonator beam, wherein the protrusion prevents conductive material from being deposited on the surface of the resonator beam corresponding to the gap.

Example 8. The method of example 7, wherein the protrusion extends from the surface of the resonator beam, wherein a distal portion of the protrusion extended away from the surface of the resonator beam has a larger lateral surface area than a base portion of the protrusion at the surface of the resonator beam.

Example 9. The method of example 8, wherein the protrusion forms at least one of an L shape, a T shape, a triangular shape, a square shape, a rectangular shape, a cylindrical shape, a spherical shape, an elliptical shape, or an elliptical cylinder shape.

Example 10. The method of any one of examples 6 through 9, wherein the feature comprises a recess extending inwards from the surface of the resonator beam into the resonator beam, wherein the recess prevents the conductive material from being in electrical connection across the gap.

Example 11. The method of example 10, wherein the recess comprises a first recess length in a first lateral direction and a first recess width in a second lateral direction, the first recess length and first recess width corresponding to a surface area of the gap, wherein the recess extends in a depth direction into the material of the resonator beam to a first depth, wherein the recess extends laterally within the material of the resonator beam at the first depth to a second width that is larger than the first width or a second length that is larger than the first length.

Example 12. The method of example 11, wherein the recess forms, within the resonator beam, at least one of an L shape, a T shape, a triangular shape, a square shape, a rectangular shape, a cylindrical shape, a spherical shape, an elliptical shape, or an elliptical cylinder shape.

Example 13. The method of any one of examples 6 through 12, wherein depositing the electrically conductive material onto the surface of the resonator beam occurs before selective laser etching the feature and forming the gap, wherein the feature comprises a portion of the piezoelectric material corresponding to a surface area of the gap that is selective laser etched and removed to form the gap.

Example 14. The method of any one of examples 6 through 13, wherein the gap is less than or equal to 250 micrometers.

Example 15. The method of any one of examples 6 through 14, wherein the surface of the resonator beam is a vertical surface of the resonator beam.

Example 16. The method of examples 15, wherein the surface is a first surface, wherein the feature is a first feature, wherein the gap is a first gap, the method further comprising: selective laser etching a second feature into the resonator beam adjacent to a second surface of the resonator beam; depositing the conductive material onto the second surface of the resonator beam adjacent to the second surface of the resonator beam adjacent to the second feature; and forming, via the second feature, a second gap within the conductive material on the second surface of the resonator beam, wherein the second gap electrically isolates the first electrode from the second electrode.

Example 17. The method of example 16, wherein the second surface is an opposing vertical surface that is parallel to the first surface.

Example 18. The method of example 16, wherein the second surface is adjacent to, and perpendicular to, the first surface.

Example 19. The method of any one of examples 15 through 18, wherein the resonator beam is a first resonator beam, wherein the surface is a first surface, wherein the feature is a first feature, wherein the gap is a first gap, the method further comprising: selective laser etching a second feature into a second resonator beam adjacent to a second surface of the second resonator beam, wherein the first resonator beam and the second resonator beam are parallel to each other in a longitudinal direction of the first and second resonator beams; depositing the conductive material onto the second surface of the second resonator beam adjacent to the second surface of the second resonator beam adjacent to the second feature; and forming, via the second feature, a second gap within the conductive material on the second surface of the second resonator beam, wherein the second gap electrically isolates the first electrode from the second electrode.

Example 20. The method of example 19, wherein the second surface is an opposing vertical surface that is parallel to the first surface.

Example 21. The method of example 19, wherein the second surface is perpendicular to the first surface.

Example 22. A resonator beam comprising: a first electrode disposed on a surface of the resonator beam; and a second electrode disposed on the surface of the resonator beam, wherein the first electrode is configured to have an opposite charge than that of the second electrode, wherein the resonator beam comprises a gap between the first electrode and the second electrode on the surface of the resonator beam, wherein the gap is less than or equal to 250 micrometers, wherein the resonator beam is configured to be connected to a first major surface of a proof mass and a first major surface of a proof mass support.

Example 23. The resonator beam of example 22, wherein the surface of the resonator beam is a vertical surface of the resonator beam parallel to a direction of motion of the proof mass.

Various examples have been described. These and other examples are within the scope of the following claims.

## Claims

1. A proof mass assembly comprising:
a proof mass;
a proof mass support;
a flexure connecting the proof mass to the proof mass support, wherein the proof mass is configured to rotate relative to the proof mass support via the flexure; and
a resonator beam connected to a first major surface of the proof mass and a first major surface of the proof mass support, the resonator beam comprising:
a first electrode disposed on a surface of the resonator beam; and
a second electrode disposed on the surface of the resonator beam,
wherein the first electrode is configured to have an opposite charge than that of the second electrode,
wherein the resonator beam comprises a gap between the first electrode and the second electrode on the surface of the resonator beam, wherein the gap is less than or equal to 250 micrometers.

2. The proof mass assembly of claim 1, wherein the surface of the resonator beam is a vertical surface of the resonator beam.

3. The proof mass assembly of claim 1 or claim 2, wherein the surface is a first surface and the gap is a first gap,
wherein the first and second electrodes are disposed on a second surface of the resonator beam that is perpendicular to the first surface;
wherein the resonator beam comprises a second gap between the first electrode and the second electrode on the second surface of the resonator beam, wherein the second gap is less than or equal to 250 micrometers.

4. The proof mass assembly of any one of claims 1-3, wherein the gap is formed via laser selective etch.

5. The proof mass assembly any one of claims 1-4, wherein the resonator beam comprises a piezoelectric material.

6. A method comprising:
selective laser etching a feature into a resonator beam adjacent to a surface of the resonator beam, wherein the resonator beam comprises a piezoelectric material;
depositing a conductive material onto the surface of the resonator beam adjacent to the feature, wherein a first electrode and a second electrode comprises the conductive material; and
forming, via the feature, a gap within the conductive material on the surface of the resonator beam, wherein the gap electrically isolates the first electrode from the second electrode.

7. The method of claim 6, wherein the feature comprises a protrusion outwards from the surface of the resonator beam, wherein the protrusion prevents conductive material from being deposited on the surface of the resonator beam corresponding to the gap.

8. The method of claim 7, wherein the protrusion extends from the surface of the resonator beam, wherein a distal portion of the protrusion extended away from the surface of the resonator beam has a larger lateral surface area than a base portion of the protrusion at the surface of the resonator beam.

9. The method of claim 8, wherein the protrusion forms at least one of an L shape, a T shape, a triangular shape, a square shape, a rectangular shape, a cylindrical shape, a spherical shape, an elliptical shape, or an elliptical cylinder shape.

10. The method of any one of claims 6-9, wherein the feature comprises a recess extending inwards from the surface of the resonator beam into the resonator beam, wherein the recess prevents the conductive material from being in electrical connection across the gap.

11. The method of claim 10, wherein the recess comprises a first recess length in a first lateral direction and a first recess width in a second lateral direction, the first recess length and first recess width corresponding to a surface area of the gap, wherein the recess extends in a depth direction into the material of the resonator beam to a first depth, wherein the recess extends laterally within the material of the resonator beam at the first depth to a second width that is larger than the first width or a second length that is larger than the first length.

12. The method of claim 11, wherein the recess forms, within the resonator beam, at least one of an L shape, a T shape, a triangular shape, a square shape, a rectangular shape, a cylindrical shape, a spherical shape, an elliptical shape, or an elliptical cylinder shape.

13. The method of any one of claims 6-12, wherein depositing the electrically conductive material onto the surface of the resonator beam occurs before selective laser etching the feature and forming the gap, wherein the feature comprises a portion of the piezoelectric material corresponding to a surface area of the gap that is selective laser etched and removed to form the gap, wherein the surface of the resonator beam is a vertical surface of the resonator beam.

14. A resonator beam comprising:
a first electrode disposed on a surface of the resonator beam; and
a second electrode disposed on the surface of the resonator beam,
wherein the first electrode is configured to have an opposite charge than that of the second electrode,
wherein the resonator beam comprises a gap between the first electrode and the second electrode on the surface of the resonator beam, wherein the gap is less than or equal to 250 micrometers,
wherein the resonator beam is configured to be connected to a first major surface of a proof mass and a first major surface of a proof mass support.

15. The resonator beam of claim 14, wherein the surface of the resonator beam is a vertical surface of the resonator beam parallel to a direction of motion of the proof mass.
